# EUROPEAN PATENT APPLICATION

(11) **EP 2 048 196 A1**
(43) Date of publication of application: **15.04.2009**
(21) Application number: 07791319.2
(22) Date of filing: 25.07.2007
(51) Int. Cl.: C08L 33/14, C08F 220/32, C09D 133/14, G03F 7/033, G03F 7/038, G03F 7/16

(54) **CURABLE RESIN COMPOSITION AND METHOD FOR FORMING CURED COATING FILM**

(30) Priority: 27.07.2006 JP 2006204621
(71) Applicant: Daicel Chemical Industries, Ltd., Kita-ku, Osaka-shi Osaka 530-0001 (JP)
(72) Inventor: MORI, Misao, Tokyo 108-8230 (JP); TAKAWAKI, Koichi, Hyogo 671-1283 (JP); NIJUKKEN, Toshihiko, Hyogo 671-1283 (JP)
(74) Representative: Grünecker, Kinkeldey, Stockmair & Schwanhäusser Anwaltssozietät
(86) International application number: PCT/JP2007/064603
(87) International publication number: WO 2008/013207

(57) **Abstract**

Disclosed is a curable resin composition which contains a copolymer; and an organic solvent having a boiling point of 180°C or higher at atmospheric pressure, which copolymer contains monomer units (A) having an alkali-soluble group, and monomer units (B) corresponding to curable group-containing polymerizable unsaturated compounds. The copolymer contains the monomer units (B) in a content of 5 to 95 percent by weight, based on the total weight of monomer units constituting the copolymer, and the monomer units (B) contain 30 percent by weight or more of monomer units corresponding to at least one compound selected from compounds containing an 3,4-epoxytricyclo[5.2.1.0^{2,6}]decane ring. The curable resin composition gives a coat which is superior typically in transparency and thermal stability and does not suffer from uneven thickness and coating defects particularly when the composition is applied through slit coating or ink-jet coating.

## Description

### Technical Field

The present invention relates to curable resin compositions each containing a copolymer having an 3,4-epoxytricyclo[5.2.1.0^{2,6}]decane ring; and processes for producing cured coatings using the curable resin compositions. More specifically, it relates to curable resin compositions, and processes for forming cured coatings using the same, which curable resin compositions are for use in lithography using active rays such as far-ultraviolet rays, electron beams, ion beams, and X-rays in processes for semiconductors, or in the formation typically of dielectric films and protective films in electronic components such as liquid crystal display devices, integrated circuit devices, and solid-state image sensors.

### Background Art

Integration of devices with higher density and higher degree of integration has been generally increasingly demanded in the field of the production of electronic devices, represented by very-large scale integrated circuits (VLSI), where micromachining at submicron dimensions is required. More and more strict requirements have therefore been made on photolithographic technologies as processes for fine patterning. Electronic components, such as liquid crystal display devices, integrated circuit devices, and solid-state image sensors, use various films such as protective films for preventing deterioration and damage of the components; interlayer dielectric films for insulating layered interconnections from each other; planarizing films for planarizing the surfaces of devices; and dielectric films for maintaining electrical insulation. Of electronic components, thin-film transistor (TFT) liquid crystal display devices as representative of liquid crystal display devices are produced in the following manner. Initially, a back substrate is prepared by forming a polarizer on a glass substrate; forming a transparent electroconductive circuit layer made typically of indium-tin oxide (ITO) and thin-film transistors (TFT) on the glass substrate; and covering these components with an interlayer dielectric film. Additionally, a front substrate is prepared by forming a polarizer on a glass substrate; patterning a black matrix layer and a color filter layer on the glass substrate according to necessity; and sequentially forming a transparent electroconductive circuit layer and an interlayer dielectric film. The back substrate and the front substrate are arranged so as to face each other with the interposition of spacers, and a liquid crystal is encapsulated in between the two substrates to give a TFT liquid crystal display device. Photosensitive resin compositions (photoresist compositions) for use therein should be superior in transparency, thermal stability, and developability and should give coats with smooth surface.

As techniques for achieving higher sensitivity of resists, there are well known chemically amplified resists using light-activatable acid generators as photosensitizers. By way of example, a curable resin composition, containing a light-activatable acid generator and a resin including an epoxy-containing structural unit, is subjected to light exposure to generate a protonic acid from the light-activatable acid generator. The generated protonic acid acts to cleave the epoxy group to induce a crosslinking reaction. By the crosslinking reaction, the resin becomes insoluble in a developer to form a pattern. Additionally, a heat treatment is conducted after light exposure to allow the acid to move in the solid phase resist pattern, and the acid thereby acts to catalytically amplify chemical changes typically of the resist resin. Thus, the resist can have a dramatically higher sensitivity as compared to known resists having photo-reaction efficiency (reaction per one photon) of less than 1. Most of currently developed resists are chemically amplified resists, and the chemical amplification mechanism should essentially be employed for the development of high-sensitivity materials that correspond to light irradiation sources having shorter wavelengths.

Dielectric films to be arranged in thin-film transistor (TFT) liquid crystal display devices and integrated circuit devices are generally made from radiation-sensitive resin compositions, because they should undergo micromachining. These radiation-sensitive resin compositions require high radiation sensitivity, so as to produce the dielectric films with high productivity. These dielectric films should also have superior solvent resistance. This is because dielectric films, if insufficiently resistant to solvents, may suffer from swelling, deformation, and delamination from the substrate by the action of organic solvents, and this may significantly impede the production of liquid crystal display devices and integrated circuit devices. Additionally, dielectric films arranged typically in liquid crystal display devices and solid-state image sensors should have high transparency according to necessity.

As a possible solution to meet these demands, Japanese Unexamined Patent Application Publication (JP-A) No. 2003-76012 discloses a photosensitive resin composition containing a copolymer between an alicyclic epoxy-containing polymerizable unsaturated compound and a free-radically polymerizable compound, in which an unsaturated carboxylic acid or the like is used as the free-radically polymerizable compound. In optically amplified resists, epoxy compounds is useful to obtain films having satisfactory etching resistance, because the epoxy compounds are easily crosslinked by the action of an acid generated with a light-activatable acid generator and by the action of subsequent heating (post-baking). Although the alicyclic epoxy-containing polymerizable unsaturated compound is highly reactive in cationic polymerization, it is highly reactive with carboxyl groups derived from the unsaturated carboxylic acid used for imparting alkali-solubility, and is thereby unstable during storage. Accordingly, the photosensitive resin composition should be stored at low temperatures of - 20°C or lower, being significantly impractical.

Japanese Patent No. 3055495 discloses a photosensitive resin composition containing a copolymer composed of a monomer unit corresponding to a (meth)acrylic ester whose oxygen atom has a bridged cyclic hydrocarbon group directly bonded thereto, a monomer unit having an epoxy-containing hydrocarbon group, and a monomer unit having a carbonyl group. However, most of such monomers corresponding to the (meth)acrylic esters whose oxygen atom has a bridged cyclic hydrocarbon group directly bonded thereto are difficult to synthesize, because of the presence of a very bulky group at the adjacent position to the ester group. Additionally, these monomers are poorly soluble in organic solvents, are thereby difficult to handle upon polymerization reaction, and the resulting resins are also difficult to handle. Further, the (meth)acrylic ester whose oxygen atom has a bridged cyclic hydrocarbon group directly bonded thereto has a very low polarity, and if copolymerized with another monomer component having high polarity, such as an unsaturated carboxylic acid or an epoxy-containing monomer, the different in polarity may cause segregation in monomer composition of the resulting polymer. This may impede the production of a polymer having a uniform composition and thereby impede the production of a resist with desired performance.

A variety of solvents are used for dissolving curable resins having curable groups such as epoxy groups. Of such solvents, ethylene glycol monoethyl ether acetate, propylene glycol monomethyl ether, and propylene glycol monomethyl ether acetate are known as solvents to give compositions that are superior in properties such as solubility, coatability, sensitivity, developability, and properties of the resulting patterns.

Spin coating, roll coating, and spraying have been widely employed for applying curable resin compositions as solutions of curable resins in solvents to substrates or bases. Recently, however, slit coating and ink-jet coating are more and more employed to form coats from these curable resin compositions, because these techniques excel in rising the rate of coating liquid use and can be conducted through less steps or within a shorter time. However, the present inventors found, as a result of investigations, coats, if made from some types of resins through slit coating or ink-jet coating, may suffer from uneven thickness of the resulting coats or may cause coating defects.

Patent Document 1: Japanese Unexamined Patent Application Publication (JP-A) No. 2003-76012
Patent Document 2: Japanese Patent No. 3055495

### Disclosure of Invention

### Problems to be Solved by the Invention

Accordingly, an object of the present invention is to provide a curable resin composition which gives a coat (cured coating) superior in characteristic properties such as hardness, transparency, thermal stability, and resistance to heat-induced discoloration and which can be stored stably to thereby give a coat free from uneven thickness and coating defects when applied through slit coating or ink-jet coating. Another object of the present invention is to provide a process for producing a cured coating using the curable resin composition.

### Means for Solving the Problems

After intensive investigations to achieve the objects, the present inventors obtained the following findings. Specifically, they made investigations to seek a polymer which is highly soluble in solvents, which gives a solution being very stable upon storage, and which gives a coat superior in properties such as transparency, thermal stability, etching resistance, surface smoothness, and developability. As a result, they found that a polymer having such superior characteristic properties can be obtained via copolymerization of a monomer mixture containing a polymerizable unsaturated compound having an alkali-soluble group, and a specific amount of another polymerizable unsaturated compound having an 3,4-epoxytricyclo[5.2.1.0^{2,6}]decane ring. However, they further found that this polymer also suffers from coating problems such as uneven coating thickness or coating defects when a coat is formed by: dissolving the polymer typically in propylene glycol monomethyl ether, which is generally believed to be superior as a solvent for photosensitive resins, to give a curable resin composition; applying the curable resin composition to a substrate or base through slit coating or ink-jet coating; and curing the applied film to give the coat. The present inventors therefore made further investigations to seek solvents not causing these problems and found that specific organic solvent are very effective for the application of the curable resin composition particularly through slit coating or ink-jet coating. The present invention has been made based on these findings.

Specifically, the present invention provides a curable resin composition comprising a copolymer and an organic solvent having a boiling point of 180°C or higher at atmospheric pressure. The copolymer contains: monomer units
(A) having an alkali-soluble group; and monomer units (B) corresponding to curable group-containing polymerizable unsaturated compounds. An amount of the monomer units (B) is 5 to 95 percent by weight based on the total weight of monomer units constituting the copolymer. The monomer units
(B) contain a monomer unit corresponding to a compound containing an 3,4-epoxytricyclo[5.2.1.0^{2,6}]decane ring and represented by following Formula (1a) or (1b): 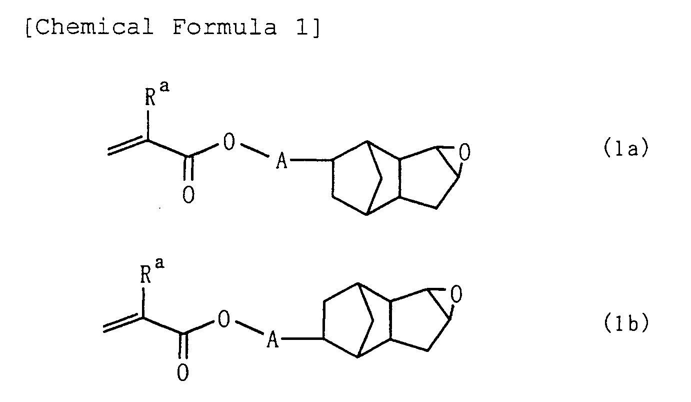 In the Formula (1a) and (1b), R^{a}s independently represent a hydrogen atom or a hydroxyl-substituted or unsubstituted alkyl group having one to seven carbon atoms; and "A"s independently represent a single bond or a bivalent hydrocarbon group which may contain a hetero atom. A total amount of the monomer units corresponding to said compounds each represented by the Formula (1a) or (1b) is 30 percent by weight or more based on the total weight of the monomer units (B).

The copolymer further may contain monomer units (C) corresponding to at least one curable group-free polymerizable unsaturated compound selected from a group consisting of: (c1) an alkyl-substituted or unsubstituted styrene; (c2) an unsaturated carboxylic acid ester represented by following Formula (2): 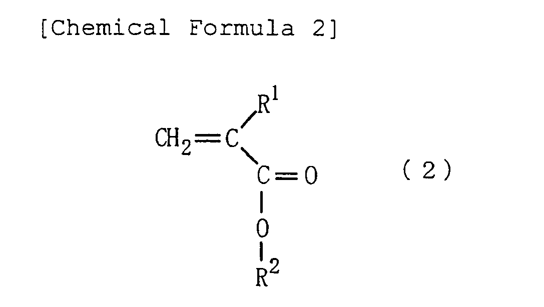 wherein R¹ represents a hydrogen atom or an alkyl group having one to seven carbon atoms; and R² represents a primary or secondary alkyl group having one to twelve carbon atoms, an alkenyl group having two to twelve carbon atoms, an aryl group, an aralkyl group, or a -(R³-O)ₘ-R⁴ group, wherein R³ represents a bivalent hydrocarbon group having one to twelve carbon atoms; R⁴ represents a hydrogen atom or a hydrocarbon group; and "m" denotes an integer of 1 or more; and
(c3) a N-substituted maleimide, in addition to the monomer units (A) and (B).

Preferably, the compound containing an 3,4-epoxytricyclo[5.2.1.0^{2,6}]decane ring and represented by Formula (1a) or (1b) is selected from a group consisting of 3,4-epoxytricyclo[5.2.1.0^{2,6}]dec-9-yl (meth)acrylates, 3,4-epoxytricyclo[5.2.1.0^{2,6}]dec-8-yl (meth)acrylates, 2-(3,4-epoxytricyclo[5.2.1.0^{2,6}]dec-9-yloxy)ethyl (meth)acrylates, and 2-(3,4-epoxytricyclo[5.2.1.0^{2,6}]dec-8-yloxy)ethyl (meth)acrylates.

The organic solvent having a boiling point of 180°C or higher at atmospheric pressure may be at least one organic solvent selected from a group consisting of a C₅ or C₆ cycloalkanediol, a C₅ or C₆ cycloalkane-dimethanol, a C₅ or C₆ cycloalkanediol mono- or di-acetate, a C₅ or C₆ cycloalkane-dimethanol mono- or di-acetate, a propylene glycol mono- or di-aryl ether, a dipropylene glycol mono(C₁-C₄ alkyl) ether, a dipropylene glycol di(C₂-C₄ alkyl) ether, a dipropylene glycol mono(C₁-C₄ alkyl) ether acetate, a tripropylene glycol mono- or di-(C₁-C₄ alkyl) ether, propylene glycol diacetate, a 1,3-propanediol di(C₃ or C₄ alkyl) ether, a 1,3-propanediol mono(C₂-C₄ alkyl) ether acetate, 1,3-propanediol mono- or di-acetate, a 1,3-butanediol mono- or di-(C₃ or C₄ alkyl) ether, a 1,3-butanediol mono(C₂-C₄ alkyl) ether acetate, 1,3-butanediol mono- or di-acetate, a 1,4-butanediol mono- or di-(C₃ or C₄ alkyl) ether, a 1,4-butanediol mono(C₂-C₄ alkyl) ether acetate, 1,4-butanediol mono- or di-acetate, a glycerol mono-, di-, or tri-(C₁-C₄ alkyl) ether, glycerol mono-, di-, or tri-acetate, a glycerol mono- or di-(C₁-C₄ alkyl) ether di- or mono-acetate, 3,5,5-trimethyl-2-cyclohexen-1-one, a diethylene glycol mono(C₂-C₄ alkyl) ether, and a diethylene glycol mono(C₂-C₄ alkyl) ether acetate.

Further, the present invention provides a process for producing a cured coating. In the present invention, the process comprises the step of applying the above-mentioned curable resin composition to a substrate or base through slit coating or ink-jet coating to form a coat and the step of curing the coat.

According to the present invention, there can be provided a resin composition which gives a coat (cured coating) superior in characteristic properties such as hardness, transparency, thermal stability, and resistance to heat-induced discoloration and which can be stably stored to thereby give a coat free from problems such as uneven thickness and coating defects particularly when applied through slit coating or ink-jet coating.

### Best Mode for Carrying Out the Invention

### [Copolymers]

A copolymer in a curable resin composition according to the present invention contains monomer units (A) having an alkali-soluble group; and monomer units (B) corresponding to curable group-containing polymerizable unsaturated compounds. The monomer units (A) having an alkali-soluble group have functions typically of imparting alkali-solubility to the polymer (copolymer). This enables the polymer to be dissolved in an alkali aqueous solution (developer) upon developing. The monomer units (B) have the function of curing the polymer in the presence of heat and/or light to give necessary hardness to the coat.

The monomer units (A) having an alkali-soluble group can be introduced into the polymer by subjecting a polymerizable unsaturated compound (a) having an alkali-soluble group to copolymerization. The alkali-soluble group has only to be a group that is generally used in resists, and examples thereof include carboxyl group and phenolic hydroxyl group. Representative examples of polymerizable unsaturated compounds (a) having an alkali-soluble group include, but are not limited to, unsaturated carboxylic acids or acid anhydrides thereof, and hydroxystyrenes or derivatives thereof. Among them, unsaturated carboxylic acids or acid anhydrides thereof are typically preferred.

Exemplary unsaturated carboxylic acids and acid anhydrides thereof include α,β-unsaturated carboxylic acids such as acrylic acid, methacrylic acid, itaconic acid, crotonic acid, maleic acid, fumaric acid, citraconic acid, and mesaconic acid, and acid anhydrides of them, such as maleic anhydride and itaconic anhydride. Among them, acrylic acid and methacrylic acid are preferred. Each of different polymerizable unsaturated compound (a) having an alkali-soluble group may be used alone or in combination.

The content (proportion) of the monomer units (A) having an alkali-soluble group in the copolymer may vary depending typically on the types of used monomers and the type (negative-working or positive-working) of the resist, but is generally 10 to 50 percent by weight, preferably 12 to 40 percent by weight, and more preferably 14 to 30 percent by weight, based on the total weight of monomer units constituting the copolymer. A copolymer, if containing the monomer units (A) in an excessively small amount, may be resistant to dissolution in an alkaline developer, and this may impede the development of the resin composition. In contrast, a copolymer, if containing the monomer units (A) in an excessively large amount, may unfavorably cause insufficient etching resistance of the resist after development.

The monomer units (B) corresponding to curable group-containing polymerizable unsaturated compounds act to cure the polymer via crosslinking with a crosslinking agent or via a reaction with an alkali-soluble group (e.g., carboxyl group or phenolic hydroxyl group) in the polymer molecule typically upon exposure to light and act to impart necessary hardness as a resist to the coat to help the coat to be more resistant to etching. In addition, they act to make the polymer insoluble in alkalis.

The monomer units (B) corresponding to curable group-containing polymerizable unsaturated compounds can be introduced into the polymer by subjecting a curable group-containing polymerizable unsaturated compound (b) to copolymerization. Preferred curable group-containing polymerizable unsaturated compounds (b) include compounds each having a group having an unsaturated bond and a polycyclic aliphatic group with an epoxy group on its ring. Exemplary polycyclic aliphatic groups include dicyclopentanyl group and tricyclodecyl group. Exemplary unsaturated bonds include carbon-carbon double bond, and exemplary groups having an unsaturated bond include vinyl group, allyl group, methallyl group, acryloyl group, and methacryloyl group.

In the present invention, at least one compound, containing an 3,4-epoxytricyclo[5.2.1.0^{2,6}]decane ring and represented by Formula (1a) or (1b), is used as a curable group-containing polymerizable unsaturated compound (b). In Formulae (1a) and (1b), R^{a}s independently represent a hydrogen atom or a hydroxyl-substituted or unsubstituted alkyl group having one to seven carbon atoms; and "A"s independently represent a single bond or a bivalent hydrocarbon group which may contain a hetero atom.

Exemplary hydroxyl-substituted or unsubstituted alkyl groups having one to seven carbon atoms, as R^{a}, include alkyl groups such as methyl, ethyl, propyl, isopropyl, butyl, isobutyl, s-butyl, pentyl, hexyl, and heptyl groups; and hydroxyalkyl groups such as hydroxymethyl group, 1-hydroxyethyl group, 2-hydroxyethyl group, 1-hydroxypropyl group, 2-hydroxypropyl group, 3-hydroxypropyl group, 1-hydroxy-1-methylethyl group, 2-hydroxy-1-methylethyl group, 1-hydroxybutyl group, 2-hydroxybutyl group, 3-hydroxybutyl group, and 4-hydroxybutyl group. R^{a} is preferably a hydrogen atom or a hydroxyl-substituted or unsubstituted alkyl group having one or two carbon atoms and is more preferably a hydrogen atom or a methyl group.

The hetero atom in bivalent hydrocarbon groups as "A" which may contain a hetero atom may be bonded at the terminal of the hydrocarbon group or interposed between carbon atoms constituting the hydrocarbon group. Exemplary hetero atoms include nitrogen, oxygen, and sulfur atoms.

Representative examples of "A" include a group represented by following Formula (3): 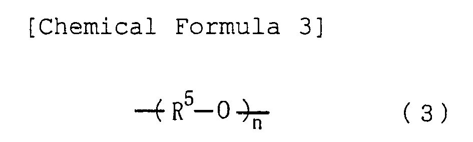 wherein R⁵ represents a bivalent hydrocarbon group having one to twelve carbon atoms; and "n" denotes an integer of 0 or more.

Exemplary bivalent hydrocarbon groups having one to twelve carbon atoms, as R⁵, include bivalent linear or branched alkylene groups such as methylene, ethylene, propylene, trimethylene, tetramethylene, hexamethylene, octamethylene, decamethylene, and dodecamethylene groups; bivalent alicyclic hydrocarbon groups including cycloalkylene groups, cycloalkylidene groups, and bivalent bridged carbocyclic groups, such as cyclopentylene, cyclohexylene, cyclopentylidene, and cyclohexylidene; and bivalent hydrocarbon groups each composed of two or more of these groups. Among them, preferred examples of R⁵ include alkylene groups having one to six carbon atoms, such as methylene, ethylene, propylene, tetramethylene, and hexamethylene groups; and alicyclic hydrocarbon groups having three to six members, such as cyclohexylene group. The repetition number "n" is preferably an integer of from 0 to 10, more preferably an integer of from 0 to 4, and particularly preferably 0 or 1.

Other representative examples of "A" include alkylene groups such as methylene group, ethylene group, propylene group, and trimethylene group, of which alkylene groups having one to twelve carbon atoms are preferred, and those having one to six carbon atoms are more preferred; thioalkylene groups such as thiomethylene group, thioethylene group, and thiopropylene group, of which thioalkylene groups having one to twelve carbon atoms are preferred, and those having one to six carbon atoms are more preferred; aminoalkylene groups such as aminomethylene group, aminoethylene group, and aminopropylene group, of which aminoalkylene groups having one to twelve carbon atoms are preferred, and those having one to six carbon atoms are more preferred.

"A" is preferably a single bond [i.e., a group of Formula (3) where "n" is 0], an alkylene group having one to six carbon atoms (of which an alkylene group having one to three carbon atoms is more preferred), or an oxyalkylene group having one to six carbon atoms (of which an oxyalkylene group having two or three carbon atoms is more preferred) [i.e., a group of Formula (3) where "n" is 1; and R⁵ is a C₁-C₆ alkylene group (of which a C₂ or C₃ alkylene group is more preferred)]. "A" is more preferably a single bond or an oxyethylene group.

Representative examples of compounds containing an 3,4-epoxytricyclo[5.2.1.0^{2,6}]decane ring represented by Formulae (1a) and (1b) include epoxidized dicyclopentenyl (meth)acrylates [3,4-epoxytricyclo[5.2.1.0^{2,6}]dec-9-yl (meth)acrylates; and 3,4-epoxytricyclo[5.2.1.0^{2,6}]dec-8-yl (meth)acrylates], epoxidized dicyclopentenyloxyethyl (meth)acrylates [2-(3,4-epoxytricyclo[5.2.1.0^{2,6}]dec-9-yloxy)ethyl (meth)acrylates; and 2-(3,4-epoxytricyclo[5.2.1.0^{2,6}]dec-8-yloxy)ethyl (meth)acrylates], epoxidized dicyclopentenyloxybutyl (meth)acrylates, and epoxidized dicyclopentenyloxyhexyl (meth)acrylates. Among them, epoxidized dicyclopentenyl (meth)acrylates and epoxidized dicyclopentenyloxyethyl (meth)acrylates are preferred.

Each of a compound represented by Formula (1a) and a compound represented by Formula (1b) can be used alone or used in combination as a mixture in an arbitrary proportion. When the two compounds are used in combination as a mixture, the ratio of the compound represented by Formula (1a) to the compound represented by Formula (1b) may be from 5:95 to 95:5, more preferably from 10:90 to 90:10, and further preferably from 20:80 to 80:20.

The copolymer may contain one or more compounds each represented by Formula (1a) or (1b) and containing an 3,4-epoxytricyclo[5.2.1.0^{2,6}]decane ring in combination with other curable group-containing polymerizable unsaturated compounds (hereinafter also referred to as "optional curable group-containing polymerizable unsaturated compounds"). Exemplary optional curable group-containing polymerizable unsaturated compounds include polymerizable unsaturated compounds containing an oxirane ring (single ring) (e.g., (meth)acrylic ester derivatives), such as oxiranyl (meth)acrylates, glycidyl (meth)acrylates, 2-methylglycidyl (meth)acrylates, 2-ethylglycidyl (meth)acrylates, 2-oxiranylethyl (meth)acrylates, 2-glycidyloxyethyl (meth)acrylates, 3-glycidyloxypropyl (meth)acrylates, and glycidyloxyphenyl (meth)acrylates; polymerizable unsaturated compounds containing an 3,4-epoxycyclohexane ring or another epoxy-containing alicyclic carbocycle (e.g., (meth)acrylic ester derivatives), such as 3,4-epoxycyclohexyl (meth)acrylates, 3,4-epoxycyclohexylmethyl (meth)acrylates, 2-(3,4-epoxycyclohexyl)ethyl (meth)acrylates, 2-(3,4-epoxycyclohexylmethyloxy)ethyl (meth)acrylates, and 3-(3,4-epoxycyclohexylmethyloxy)propyl (meth)acrylates; and polymerizable unsaturated compounds containing an 5,6-epoxy-2-bicyclo[2.2.1]heptane ring (e.g., (meth)acrylic ester derivatives), such as 5,6-epoxy-2-bicyclo[2.2.1]heptyl (meth)acrylates.

Exemplary optional curable group-containing polymerizable unsaturated compounds further include polymerizable unsaturated compounds containing an oxetane ring, such as oxetanyl (meth)acrylates, 3-methyl-3-oxetanyl (meth)acrylates, 3-ethyl-3-oxetanyl (meth)acrylates, (3-methyl-3-oxetanyl)methyl (meth)acrylates, (3-ethyl-3-oxetanyl)methyl (meth)acrylates, 2-(3-methyl-3-oxetanyl)ethyl (meth)acrylates, 2-(3-ethyl-3-oxetanyl)ethyl (meth)acrylates, 2-[(3-methyl-3-oxetanyl)methyloxy]ethyl (meth)acrylates, 2-[(3-ethyl-3-oxetanyl)methyloxy]ethyl (meth)acrylates, 3-[(3-methyl-3-oxetanyl)methyloxy]propyl (meth)acrylates, and 3-[(3-ethyl-3-oxetanyl)methyloxy]propyl (meth)acrylates; and polymerizable unsaturated compounds containing an oxolane ring, such as tetrahydrofurfuryl (meth)acrylates. In addition, exemplary optional curable group-containing polymerizable unsaturated compounds further include vinyl ether compounds containing an oxirane ring, oxetane ring, or oxolane ring; and allyl ether compounds containing an oxirane ring, oxetane ring, or oxolane ring.

The content of monomer units (B) corresponding to curable group-containing polymerizable unsaturated compounds in the copolymer is 5 to 95 percent by weight, preferably 40 to 90 percent by weight, and more preferably 45 to 85 percent by weight, based on the total weight of monomer units. If the content is less than 5 percent by weight, crosslinking typically upon light irradiation may not sufficiently proceed, and this may cause deterioration of thermal stability and etching resistance of the resin composition. In contrast, if the content is more than 95 percent by weight, the resin composition may have insufficient characteristic properties such as alkali solubility, and this may impede satisfactory patterning.

The total content of monomer units corresponding to compounds represented by Formula (1a) and/or (1b) each containing an 3,4-epoxytricyclo[5.2.1.0^{2,6}]decane ring in the monomer units (B) corresponding to the curable group-containing polymerizable unsaturated compounds is 30 percent by weight or more, preferably 50 percent by weight or more, and more preferably 70 percent by weight or more. If the content is less than 30 percent by weight, the copolymer may show insufficient properties required as a radiation-sensitive resin. In this case, for example, when compounds represented by Formula (1a) and/or (1b) are used in combination with a polymerizable unsaturated compound containing an epoxy-containing alicyclic carbocycle, the resulting resin composition may be insufficiently stable upon storage; and if the compounds are used in combination with a polymerizable unsaturated compound containing an oxirane ring (single ring), such as a glycidyl-containing monomer, the resin composition may be insufficiently thermally stable.

The copolymer for use herein may further contain, in addition to the monomer units (A) and (B), monomer units (C) corresponding to at least one curable group-free polymerizable unsaturated compound selected from (c1) an alkyl-substituted or unsubstituted styrene, (c2) an unsaturated carboxylic acid ester represented by Formula (2), and (c3) a N-substituted maleimide. In Formula (2), R¹ represents a hydrogen atom or an alkyl group having one to seven carbon atoms; R² represents a primary or secondary alkyl group having one to twelve carbon atoms, an alkenyl group having two to twelve carbon atoms, an aryl group, an aralkyl group, or a -(R³-O)ₘ-R⁴ group, wherein R³ represents a bivalent hydrocarbon group having one to twelve carbon atoms; R⁴ represents a hydrogen atom or a hydrocarbon group; and "m" denotes an integer of 1 or more. The monomer units (C) act to impart hardness necessary typically as a resist to the coat. Some monomers corresponding to these monomers help the copolymerization to proceed smoothly. In addition, monomer units (C) of some types help the coat to have higher hardness as a result typically of crosslinking.

Exemplary alkyl groups in the alkyl-substituted or unsubstituted styrene (c1) include alkyl groups having about one to seven carbon atoms, such as methyl, ethyl, propyl, isopropyl, butyl, isobutyl, t-butyl, and hexyl groups. Among them, preferred are alkyl groups having one to four carbon atoms, such as methyl group or ethyl group, of which methyl group is more preferred. The alkyl group may be bonded to either of vinyl group and benzene ring of styrene. Representative exemplary alkyl-substituted or unsubstituted styrenes (c1) include styrene, α-methylstyrene, and vinyltoluenes (o-vinyltoluene, m-vinyltoluene, and p-vinyltoluene). Each of these may be used alone or in combination.

In unsaturated carboxylic acid esters (c2) represented by Formula (2), exemplary alkyl groups having one to seven carbon atoms as R¹ include methyl, ethyl, propyl, isopropyl, butyl, isobutyl, t-butyl, and hexyl groups. In particular, R¹ is preferably a hydrogen atom or methyl group.

Exemplary primary or secondary alkyl groups having one to twelve carbon atoms as R² include methyl, ethyl, propyl, isopropyl, butyl, isobutyl, s-butyl, hexyl, octyl, decyl, and dodecyl groups. Exemplary alkenyl groups having two to twelve carbon atoms include primary or secondary alkenyl groups such as allyl, 3-butenyl, and 5-hexenyl groups. Exemplary aryl groups include phenyl group. Exemplary aralkyl groups include benzyl group.

In the -(R³-O)ₘ-R⁴ group as R², R³ represents a bivalent hydrocarbon group having one to twelve carbon atoms; R⁴ represents a hydrogen atom or a hydrocarbon group; and "m" denotes an integer of 1 or more. Exemplary bivalent hydrocarbon groups having one to twelve carbon atoms herein include the bivalent hydrocarbon groups having one to twelve carbon atoms listed as R⁵. Among them, particularly preferred examples are alkylene groups having two to six carbon atoms, such as ethylene, propylene, tetramethylene, and hexamethylene groups; and alicyclic hydrocarbon groups having three to six members, such as cyclohexylene group. Exemplary hydrocarbon groups as R⁴ include aliphatic hydrocarbon groups including alkyl groups such as methyl, ethyl, propyl, isopropyl, butyl, and hexyl groups, of which alkyl groups having one to six carbon atoms are preferred; alicyclic hydrocarbon groups including cycloalkyl groups such as cyclopentyl group and cyclohexyl group, and bridged carbocyclic groups such as norbornyl group (bicyclo[2.2.1]heptyl group) and tricyclo[5.2.1.0^{2,6}]decyl group; and groups each composed of two or more of these groups. The repetition number "m" is preferably an integer of 1 to 10, more preferably an integer of 1 to 4, and particularly preferably 1.

Representative exemplary unsaturated carboxylic acid esters (c2) represented by Formula (2) include methyl (meth)acrylates, ethyl (meth)acrylates, propyl (meth)acrylates, isopropyl (meth)acrylates, butyl (meth)acrylates, allyl (meth)acrylates, phenyl (meth)acrylates, benzyl (meth)acrylates, 2-hydroxyethyl (meth)acrylates, 2-hydroxypropyl (meth)acrylates, and 2-(tricyclo[5.2.1.0^{2,6}]decyloxy)ethyl (meth)acrylates. Each of different unsaturated carboxylic acid esters (c2) represented by Formula (2) may be used alone or in combination.

Exemplary usable N-substituted maleimides (c3) include compounds represented by following Formula (4): 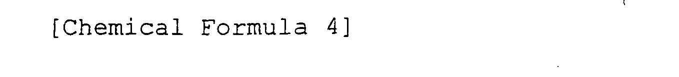 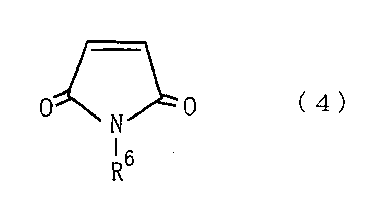 wherein R⁶ represents an organic group.

Exemplary organic groups are hydrocarbon groups and heterocyclic groups. Exemplary hydrocarbon groups include aliphatic hydrocarbon groups including alkyl groups such as methyl, ethyl, propyl, isopropyl, butyl, and hexyl groups, of which alkyl groups having one to six carbon atoms are preferred; alicyclic hydrocarbon groups including cycloalkyl groups such as cyclopentyl group, cyclohexyl group, and cyclooctyl group, and bridged carbocyclic groups such as adamantyl group and norbornyl group; aryl groups such as phenyl group; aralkyl groups such as benzyl group; and groups each composed of two or more of these groups. Exemplary heterocyclic groups include nonaromatic or aromatic heterocyclic groups each containing at least one hetero atom selected from the group consisting of nitrogen atom, oxygen atom, and sulfur atom and having about five to ten members.

Representative exemplary N-substituted maleimides (c3) include N-cycloalkylmaleimides such as N-cyclopentylmaleimide, N-cyclohexylmaleimide, and N-cyclooctylmaleimide; N-(bridged carbocyclic group)-substituted maleimides such as N-adamantylmaleimide and N-norbornylmaleimide; N-alkylmaleimides such as N-methylmaleimide, N-ethylmaleimide, and N-propylmaleimide; N-arylmaleimides such as N-phenylmaleimide; and N-aralkylmaleimides such as N-benzylmaleimide. Among them, preferred are N-cycloalkylmaleimides such as N-cyclohexylmaleimide; and N-(bridged carbocyclic group)-substituted maleimides. Each of different N-substituted maleimides (c3) may be used alone or in combination.

A copolymer for use herein may further contain small amounts of some other monomer units, in addition to the monomer units (A), monomer units (B), and monomer units (C). Examples of the other monomer units include units corresponding to (meth)acrylamide and (meth)acrylonitrile. When the copolymer for use herein contains the monomer units (A) and the monomer units (B) but does not contain the monomer units (C), the total amount of the monomer units (A) and the monomer units (B) is generally 98 percent by weight or more, preferably 99 percent by weight or more, and more preferably substantially 100 percent by weight, based on the total weight of monomer units. When the copolymer contains the monomer units (A), the monomer units (B), and the monomer units (C), the total amount of the three monomer units is, for example, 90 percent by weight or more, preferably 95 percent by weight or more, more preferably 98 percent by weight or more, and particularly preferably substantially 100 percent by weight, based on the total weight of monomer units.

A copolymer for use herein may be prepared by carrying out copolymerization of a monomer mixture which contains the polymerizable unsaturated compounds (a) having an alkali-soluble group and the curable group-containing polymerizable unsaturated compounds (b). The curable group-containing polymerizable unsaturated compounds (b) occupy 5 to 95 percent by weight of the total amount of the monomer mixture. Further, the curable group-containing polymerizable unsaturated compounds (b) contain the compounds represented by Formula (1a) and/or (1b) containing an 3,4-epoxytricyclo[5.2.1.0^{2,6}]decane ring of 30 percent by weight or more of the amount of the compounds (b).

Polymerization initiators for use in the copolymerization may be regular free-radical polymerization initiators. Examples thereof include azo compounds such as 2,2'-azobisisobutyronitrile, 2,2'-azobis(2,4-dimethylvaleronitrile), 2,2'-azobis(4-methoxy-2,4-dimethylvaleronitrile), dimethyl 2,2'-azobis(2-methylpropionate), diethyl 2,2'-azobis(2-methylpropionate), and dibutyl 2,2'-azobis(2-methylpropionate); organic peroxides such as benzoyl peroxide, lauroyl peroxide, t-butyl peroxypivalate, and 1,1-bis(t-butylperoxy)cyclohexane; and hydrogen peroxide. A peroxide, if used as a free-radical polymerization initiator, may be used as a redox initiator in combination with a reducing agent. Of the polymerization initiators, azo compounds are preferred, of which 2,2'-azobisisobutyronitrile, 2,2'-azobis(2,4-dimethylvaleronitrile), and dimethyl 2,2'-azobis(2-methylpropionate) are more preferred.

The amount of polymerization initiators can be suitably selected within ranges not impeding smooth copolymerization, but is generally about 1 to 10 percent by weight, and preferably about 2 to 8 percent by weight, based on the total weight of monomers (all monomer components) and polymerization initiators.

The copolymerization can be carried out according to a common procedure used for the production of styrenic polymers or acrylic polymers, such as solution polymerization, mass (bulk) polymerization, suspension polymerization, mass-suspension polymerization, and emulsion polymerization. Among these procedures, solution polymerization is preferred. Each of monomers and polymerization initiators may be fed to the reaction system as a whole. A part or all of each of monomers or polymerization initiators may be added dropwise to the reaction system. Typically, the copolymerization may be conducted by adding a solution of a polymerization initiator in a polymerization solvent dropwise to a mixture of monomers and the polymerization solvent held at a constant temperature; or by adding a previously prepared solutions of monomers and a polymerization initiator in a polymerization solvent dropwise to the polymerization solvent held at a constant temperature (dropping polymerization).

The polymerization solvent can be suitably selected according typically to the monomer composition (monomer formulation). Exemplary polymerization solvents include ethers, esters, ketones, amides, sulfoxides, alcohols, hydrocarbons, and any mixtures of them. Exemplary ethers include diethyl ether; chain ethers including glycol ethers such as ethylene glycol mono- or di-alkyl ethers, diethylene glycol mono- or di-alkyl ethers, propylene glycol mono- or di-alkyl ethers, propylene glycol mono- or di-aryl ethers, dipropylene glycol mono- or di-alkyl ethers, tripropylene glycol mono- or di-alkyl ethers, 1,3-propanediol mono- or di-alkyl ethers, 1,3-butanediol mono- or di-alkyl ethers, 1,4-butanediol mono- or di-alkyl ethers, and glycerol mono-, di-, or tri-alkyl ethers; and cyclic ethers such as tetrahydrofuran and dioxane. Exemplary esters include carboxylic acid esters such as methyl acetate, ethyl acetate, butyl acetate, isoamyl acetate, ethyl lactate, methyl 3-methoxypropionate, ethyl 3-ethoxypropionate, C₅ or C₆ cycloalkanediol mono- or di-acetates, and C₅ or C₆ cycloalkane-dimethanol mono- or di-acetates; glycol acetates and glycol ether acetates, such as ethylene glycol monoalkyl ether acetates, ethylene glycol mono- or di-acetate, diethylene glycol monoalkyl ether acetates, diethylene glycol mono- or di-acetate, propylene glycol monoalkyl ether acetates, propylene glycol mono- or di-acetate, dipropylene glycol monoalkyl ether acetates, dipropylene glycol mono- or di-acetate, 1,3-propanediol monoalkyl ether acetates, 1,3-propanediol mono- or di-acetate, 1,3-butanediol monoalkyl ether acetates, 1,3-butanediol mono- or di-acetate, 1,4-butanediol monoalkyl ether acetates, 1,4-butanediol mono- or di-acetate, glycerol mono-, di-, or tri-acetate, glycerol mono- or di-(C₁-C₄ alkyl) ether di- or mono-acetates, tripropylene glycol monoalkyl ether acetates, and tripropylene glycol mono- or di-acetate. Exemplary ketones include acetone, methyl ethyl ketone, methyl isobutyl ketone, cyclohexanone, and 3,5,5-trimethyl-2-cyclohexen-1-one. Exemplary amides include N,N-dimethylacetamide and N,N-dimethylformamide. Exemplary sulfoxides include dimethyl sulfoxide. Exemplary alcohols include methanol, ethanol, propanol, C₅ or C₆ cycloalkanediols, and C₅ or C₆ cycloalkane-dimethanols. Exemplary hydrocarbons include aromatic hydrocarbons such as benzene, toluene, and xylenes; aliphatic hydrocarbons such as hexane; and alicyclic hydrocarbons such as cyclohexane. The polymerization temperature may be suitably selected within a range typically of about 30°C to 150°C.

The above process gives a copolymer for use herein. The copolymer may have a number-average molecular weight of, for example, about 3000 to 50000, preferably about 3500 to 40000, and more preferably about 4000 to 30000. The copolymer may have a polydispersity [(weight-average molecular weight Mw)/(number-average molecular weight Mn)] of about 1 to 3.

The resulting polymerization mixture can be used as a curable resin composition by carrying out a procedure according to necessity, such as adjustment of solid content, solvent replacement, and/or filtration, and thereafter adding to the mixture suitable additives and solvents according to the use. Alternatively, a polymer prepared through the polymerization may be once purified typically through precipitation or reprecipitation, and the purified polymer together with the suitable additives may be dissolved in a solvent, such as a resist solvent, to give a curable resin composition.

### [Curable Resin Compositions]

One of key features of a curable resin composition according to the present invention is that it contains an organic solvent having a boiling point at atmospheric pressure (0.101 MPa) of 180°C or higher as a solvent. The copolymer, obtained with a copolymerization of a monomer mixture containing a polymerizable unsaturated compound having an alkali-soluble group, and a specific amount of a polymerizable unsaturated compound having an 3,4-epoxytricyclo[5.2.1.0^{2,6}]decane ring, suffers from problems of coating, such as uneven coating thickness or coating defects, when a coat is formed by: dissolving the copolymer typically in propylene glycol monomethyl ether, which is generally believed to be superior as a solvent for resists, to give a resin composition; applying the resin composition to a substrate or base through slit coating or ink-jet coating; and curing the applied coat. In contrast, in the present invention, the copolymer is free from such problems when the copolymer is dissolved in the specific organic solvent and applied to a substrate or base through slit coating or ink-jet coating. While reasons remain unknown, this is probably because as follows. Specifically, such organic solvents having a boiling point of 180°C or higher at atmospheric pressure are dried slowly, generally have a high viscosity, and have a relatively high molecular weight. Additionally, most of them contain some amounts of hetero atoms such as oxygen atoms and thereby show satisfactory affinity for the polymer having an 3,4-epoxytricyclo[5.2.1.0^{2,6}]decane skeleton to thereby help the system to be more stable. Probably for these reasons, the resulting composition remains uniform and is prevented typically from precipitation or separation of the polymer therein on or after application even when the composition is applied via slit coating or ink-jet coating in which the composition passes through a narrow passage.

Exemplary organic solvents having a boiling point of 180°C or higher at atmospheric pressure include glycols (including trihydric or higher alcohols), glycol ethers, glycol ether esters, glycol esters, and ketones. More specific examples of such organic solvents include C₅ or C₆ cycloalkanediols, C₅ or C₆ cycloalkane-dimethanols, C₅ or C₆ cycloalkanediol mono- or di-acetates, C₅ or C₆ cycloalkane-dimethanol mono- or di-acetates, propylene glycol mono- or di-aryl ethers, dipropylene glycol mono(C₁-C₄ alkyl) ethers, dipropylene glycol di(C₂-C₄ alkyl) ethers, dipropylene glycol mono(C₁-C₄ alkyl) ether acetates, tripropylene glycol mono- or di-(C₁-C₄ alkyl) ethers, propylene glycol diacetate, 1,3-propanediol di(C₃ or C₄ alkyl) ethers, 1,3-propanediol mono(C₂-C₄ alkyl) ether acetates, 1,3-propanediol mono- or di-acetate, 1,3-butanediol mono- or di-(C₃ or C₄ alkyl) ethers, 1,3-butanediol mono (C₂-C₄ alkyl) ether acetates, 1,3-butanediol mono- or di-acetate, 1,4-butanediol mono- or di-(C₃ or C₄ alkyl) ethers, 1,4-butanediol mono(C₂-C₄ alkyl) ether acetates, 1,4-butanediol mono- or di-acetate, glycerol mono-, di-, or tri-(C₁-C₄ alkyl) ethers, glycerol mono-, di-, or tri-acetate, glycerol mono- or di-(C₁-C₄ alkyl) ether di- or mono-acetates, 3,5,5-trimethyl-2-cyclohexen-1-one, diethylene glycol mono(C₂-C₄ alkyl) ethers, and diethylene glycol mono(C₂-C₄ alkyl) ether acetates. Each of different organic solvents may be used alone or in combination.

Exemplary C₅ or C₆ cycloalkanediols are cyclopentanediols and cyclohexanediols. Exemplary C₅ or C₆ cycloalkane-dimethanols are cyclopentanedimethanols and cyclohexanedimethanols. Exemplary C₅ or C₆ cycloalkanediol mono- or di-acetates are cyclopentanediol monoacetates, cyclopentanediol diacetates, cyclohexanediol monoacetates, and cyclohexanediol diacetates. Exemplary C₅ or C₆ cycloalkane-dimethanol mono- or di-acetates are cyclopentanedimethanol monoacetates, cyclopentanedimethanol diacetates, cyclohexanedimethanol monoacetates, and cyclohexanedimethanol diacetates.

Exemplary propylene glycol mono- or di-aryl ethers include propylene glycol monophenyl ether and propylene glycol diphenyl ether.

Exemplary dipropylene glycol mono(C₁-C₄ alkyl) ethers include dipropylene glycol monomethyl ether, dipropylene glycol monoethyl ether, dipropylene glycol monopropyl ether, and dipropylene glycol monobutyl ether. Exemplary dipropylene glycol di(C₂-C₄ alkyl) ethers include dipropylene glycol diethyl ether, dipropylene glycol dipropyl ether, dipropylene glycol dibutyl ether, dipropylene glycol ethyl propyl ether, dipropylene glycol ethyl butyl ether, and dipropylene glycol propyl butyl ether. Exemplary dipropylene glycol mono(C₁-C₄ alkyl) ether acetates include dipropylene glycol monomethyl ether acetate, dipropylene glycol monoethyl ether acetate, dipropylene glycol monopropyl ether acetate, and dipropylene glycol monobutyl ether acetate.

Exemplary tripropylene glycol mono- or di-(C₁-C₄ alkyl) ethers include tripropylene glycol monomethyl ether, tripropylene glycol monoethyl ether, tripropylene glycol monopropyl ether, tripropylene glycol monobutyl ether, tripropylene glycol dimethyl ether, tripropylene glycol diethyl ether, tripropylene glycol dipropyl ether, tripropylene glycol dibutyl ether, tripropylene glycol methyl ethyl ether, tripropylene glycol methyl propyl ether, tripropylene glycol methyl butyl ether, tripropylene glycol ethyl propyl ether, tripropylene glycol ethyl butyl ether, and tripropylene glycol propyl butyl ether.

Exemplary 1,3-propanediol di(C₃ or C₄ alkyl) ethers include 1,3-propanediol dipropyl ether, 1,3-propanediol dibutyl ether, and 1,3-propanediol propyl butyl ether. Exemplary 1,3-propanediol mono(C₂-C₄ alkyl) ether acetates include 1,3-propanediol monoethyl ether acetate, 1,3-propanediol monopropyl ether acetate, and 1,3-propanediol monobutyl ether acetate.

Exemplary 1,3-butanediol mono- or di-(C₃ or C₄ alkyl) ethers include 1,3-butanediol monopropyl ether, 1,3-butanediol monobutyl ether, 1,3-butanediol dipropyl ether, 1,3-butanediol dibutyl ether, and 1,3-butanediol propyl butyl ether. Exemplary 1,3-butanediol mono(C₂-C₄ alkyl) ether acetates include 1,3-butanediol monoethyl ether acetate, 1,3-butanediol monopropyl ether acetate, and 1,3-butanediol monobutyl ether acetate.

Exemplary 1,4-butanediol mono- or di-(C₃ or C₄ alkyl) ethers include 1,4-butanediol monopropyl ether, 1,4-butanediol monobutyl ether, 1,4-butanediol dipropyl ether, 1,4-butanediol dibutyl ether, and 1,4-butanediol propyl butyl ether. Exemplary 1,4-butanediol mono(C₂-C₄ alkyl) ether acetates include 1,4-butanediol monoethyl ether acetate, 1,4-butanediol monopropyl ether acetate, and 1,4-butanediol monobutyl ether acetate.

Exemplary glycerol mono-, di-, or tri-(C₁-C₄ alkyl) ethers include glycerol monomethyl ether, glycerol monoethyl ether, glycerol monopropyl ether, and glycerol monobutyl ether. Exemplary glycerol mono- or di-(C₁-C₄ alkyl) ether di- or mono-acetates include glycerol monomethyl ether monoacetate, glycerol monoethyl ether monoacetate, glycerol monopropyl ether monoacetate, glycerol monobutyl ether monoacetate, glycerol monomethyl ether diacetate, glycerol monoethyl ether diacetate, glycerol monopropyl ether diacetate, and glycerol monobutyl ether diacetate.

Exemplary diethylene glycol mono(C₂-C₄ alkyl) ethers include diethylene glycol monoethyl ether, diethylene glycol monopropyl ether, and diethylene glycol monobutyl ether. Exemplary diethylene glycol mono(C₂-C₄ alkyl) ether acetates include diethylene glycol monoethyl ether acetate, diethylene glycol monopropyl ether acetate, and diethylene glycol monobutyl ether acetate.

Of these organic solvents, preferred is at least one organic solvent selected from dipropylene glycol mono- or di-(C₂-C₄ alkyl) ethers, dipropylene glycol mono(C₁-C₄ alkyl) ether acetates, 1,3-butanediol mono- or di-(C₃ or C₄ alkyl) ethers, 1,3-butanediol mono(C₂-C₄ alkyl) ether acetates, and 1,3-butanediol mono- or di-acetate, of which more preferred is at least one organic solvent selected from dipropylene glycol mono(C₂-C₄ alkyl) ethers, dipropylene glycol mono(C₁-C₄ alkyl) ether acetates, and 1,3-butanediol diacetate. The boiling point at atmospheric pressure of the organic solvents is 180°C or higher (e.g., 180°C to 280°C), preferably 200°C or higher (e.g., 200°C to 280°C), and more preferably 220°C or higher (e.g., 220°C to 280°C).

The organic solvents may be used in combination with additional organic solvents according to necessity. Such additional organic solvents can be selected from among organic solvents having a boiling point at atmospheric pressure of lower than 180°C, and examples thereof include glycol ethers, glycol ether esters, glycol esters, carboxylic acid alkyl esters, and aliphatic ketones. Representative examples thereof are listed below. A number in the parentheses after the name of a compound represents the boiling point of the compound at atmospheric pressure.

Exemplary glycol ethers include propylene glycol monomethyl ether (120°C), propylene glycol dimethyl ether (96°C), diethylene glycol dimethyl ether (162°C), and dipropylene glycol dimethyl ether (175°C).

Exemplary glycol ether esters include ethylene glycol monoethyl ether acetate (156°C), propylene glycol monomethyl ether acetate (146°C), and 1,3-butanediol monomethyl ether acetate (i.e., 3-methoxybutyl acetate) (171°C).

Exemplary carboxylic acid alkyl esters include isoamyl acetate (142°C), ethyl lactate (155°C), methyl 3-methoxypropionate (142°C), and ethyl 3-ethoxypropionate (170°C).

Exemplary aliphatic ketones include 2-butanone, 2-pentanone, 2-hexanone, and 2-heptanone.

Typically, in an embodiment, glycol ether esters (e.g., propylene glycol monomethyl ether acetate), glycol esters, and carboxylic acid alkyl esters are preferably used as additional organic solvents when glycol ethers are used as the organic solvents having a boiling point of 180°C or higher at atmospheric pressure. Exemplary glycol ethers herein include propylene glycol mono- or di-aryl ethers, dipropylene glycol mono(C₁-C₄ alkyl) ethers, dipropylene glycol di(C₂-C₄ alkyl) ethers, tripropylene glycol mono- or di-(C₁-C₄ alkyl) ethers, 1,3-propanediol di(C₃ or C₄ alkyl) ethers, 1,3-butanediol mono- or di-(C₃ or C₄ alkyl) ethers, 1,4-butanediol mono- or di-(C₃ or C₄ alkyl) ethers, glycerol mono-, di-, or tri-(C₁-C₄ alkyl) ethers, and diethylene glycol mono(C₂-C₄ alkyl) ethers.

In another embodiment, glycol ethers such as dipropylene glycol dimethyl ether are preferably used as additional solvents when glycol ether esters and/or glycol esters are used as the organic solvents having a boiling point of 180°C or higher at atmospheric pressure. Exemplary glycol ether esters herein include C₅ or C₆ cycloalkane-dimethanol mono- or di-acetates, dipropylene glycol mono(C₁-C₄ alkyl) ether acetates, 1,3-propanediol mono(C₂-C₄ alkyl) ether acetates, 1,3-butanediol mono(C₂-C₄ alkyl) ether acetates, 1,4-butanediol mono(C₂-C₄ alkyl) ether acetates, glycerol mono- or di-(C₁-C₄ alkyl) ether di- or mono-acetates, and diethylene glycol mono(C₂-C₄ alkyl) ether acetates. Exemplary glycol esters include C₅ or C₆ cycloalkanediol mono- or di-acetates, C₅ or C₆ cycloalkane-dimethanol mono- or di-acetates, propylene glycol diacetate, 1,3-propanediol mono- or di-acetate, 1,3-butanediol mono- or di-acetate, 1,4-butanediol mono- or di-acetate, and glycerol mono-, di-, or tri-acetate.

An organic solvent having a boiling point of 180°C or higher at atmospheric pressure may be used as a polymerization solvent and subsequently used as a solvent in a curable resin composition; or may be used as a solvent for dissolving the polymer to prepare a curable resin composition. An additional organic solvent, if used in combination with the specific organic solvent, may be used as a polymerization solvent and subsequently used as a solvent in a curable resin composition; or may be used as a solvent for dissolving the polymer to prepare a curable resin composition. The additional organic solvent is, however, frequently used as the polymerization solvent.

The total amount of the organic solvents having a boiling point of 180°C or higher at atmospheric pressure herein is preferably 10 percent by weight or more, more preferably 15 percent by weight or more, further preferably 50 percent by weight or more, and particularly preferably 80 percent by weight or more, based on the total weight of organic solvents in the curable resin composition. The organic solvents in the curable resin composition may be substantially composed of the organic solvents having a boiling point of 180°C or higher at atmospheric pressure alone. The total amount of the organic solvents in the curable resin composition is generally about 10 to 99 percent by weight, and preferably about 50 to 90 percent by weight, based on the total weight of the curable resin composition.

The curable resin compositions according to the present invention may further contain suitable additives according to uses. Exemplary additives include, but are not limited to, light-activatable acid generators, crosslinking agents, resins, colorants, polymerization initiators (e.g., light-induced cationic polymerization initiators and heat-induced cationic polymerization initiators), antioxidants, dissolution inhibitors, sensitizers, ultraviolet-absorbers, light stabilizers, and adhesion improvers. The curable resin composition, if used as a radiation-sensitive resin composition or a photosensitive resin composition, often contains quinone diazide compounds as additives. The quinone diazide compounds can be compounds generally used in radiation-sensitive resin compositions and photosensitive resin compositions. The amount of quinone diazide compounds is, for example, 2 to 100 percent by weight, and preferably 5 to 40 percent by weigh, based on the total solid content of the curable resin composition.

The curable resin compositions according to the present invention can be used in the formation of coats typically through spraying, roll coating or spin coating, but they are particularly useful in the formation of coats through slit coating or ink-jet coating in which the composition passes through a narrow passage. The curable resin compositions give, after curing, coats that are superior in characteristic properties such as hardness, transparency, thermal stability, and resistance to heat-induced discoloration. They can therefore be advantageously used as curable resin compositions for the formation typically of protective films and interlayer dielectric films used typically in liquid crystal display devices, integrated circuit devices, and solid-state image sensors.

### [Process for Producing Cured Coatings]

In the process for producing a cured coating according to the present invention, the curable resin composition according to the present invention is applied to a substrate or base through slit coating or ink-jet coating to form a coat, and the coat is cured. Exemplary substrates or bases include those made of glass, ceramics, silicon wafers, metals, and plastics. The application through slit coating or ink-jet coating can be carried out according to a common procedure. The curable resin composition, if used as a radiation-sensitive resin composition or photosensitive resin composition, can give a desired pattern by: applying the curable resin composition to a substrate or base to form a coat; applying radiation (light) to the coat through a predetermined mask; and subsequently carrying out development of the pattern. The light application can be conducted using rays with various wavelengths, such as ultraviolet rays and X-rays. For semiconductor resists, gray, i-ray, and excimer laser beams, for example, may be used. Exemplary usable developers include aqueous alkali (base) solutions such as aqueous tetramethylammonium hydroxide solutions.

The curing of the coat may be conducted by the action of heat and/or light. The thickness of the cured coating (typically as a protective film, an interlayer dielectric film, a character, or a pattern) may be suitably selected according to the use, but is generally from about 0.1 to 20 µm, and preferably from about 0.3 to 10 µm.

### Examples

The present invention will be illustrated in further detail with reference to several examples below. It should be noted, however, that these examples are never construed to limit the scope of the present invention. A number in the parentheses following the name of a compound refers to the boiling point of the compound at atmospheric pressure. A "polydispersity" indicates a value represented by the expression: (weight-average molecular weight Mw)/(number-average molecular weight Mn).

### PREPARATION EXAMPLE 1

A suitable amount of nitrogen was fed into a 1-liter flask equipped with a reflux condenser, dropping funnels, and a stirrer to give a nitrogen atmosphere. In the flask was placed 275 parts by weight of dipropylene glycol dimethyl ether (175°C), followed by heating to 70°C with stirring. Next, 55 parts by weight of methacrylic acid (MAA), 180 parts by weight of a 50:50 (molar ratio) mixture (E-DCPA) of 3,4-epoxytricyclo[5.2.1.0^{2,6}]dec-9-yl acrylate and 3,4-epoxytricyclo[5.2.1.0^{2,6}]dec-8-yl acrylate, and 70 parts by weight of N-cyclohexylmaleimide (CHMI) were dissolved in 170 parts by weight of dipropylene glycol dimethyl ether to obtain a solution. The solution was fed dropwise into the flask over about four hours with a dropping pump. Independently, 30 parts by weight of a polymerization initiator 2,2'-azobis(2,4-dimethylvaleronitrile) was dissolved in 225 parts by weight of dipropylene glycol dimethyl ether to obtain another solution. The solution was fed dropwise into the flask over about four hours with another dropping pump. After the completion of dropwise addition of the polymerization initiator, the mixture was held at the same temperature for about four hours, then cooled to room temperature, and thereby yielded a copolymer solution having a solid content of 30.3 percent by weight and an acid value of 35.7 mg-KOH/g. The prepared copolymer had an acid value of 118 mg-KOH/g, a weight-average molecular weight Mw of 9000, and a polydispersity of 1.80.

### PREPARATION EXAMPLE 2

A suitable amount of nitrogen was fed into a 1-liter flask equipped with a reflux condenser, dropping funnels, and a stirrer to give a nitrogen atmosphere. In the flask was placed 345 parts by weight of dipropylene glycol dimethyl ether (175°C), followed by heating to 70°C with stirring. Next, 76 parts by weight of methacrylic acid (MAA) and 303 parts by weight of a 50:50 (molar ratio) mixture (E-DCFA) of 3,4-epoxytricyclo[5.2.1.0^{2,6}]dec-9-yl acrylate and 3,4-epoxytricyclo[5.2.1.0^{2,6}]dec-8-yl acrylate were dissolved in 220 parts by weight of dipropylene glycol dimethyl ether to obtain a solution. The solution was fed dropwise into the flask over about four hours with a dropping pump. Independently, 70 parts by weight of a polymerization initiator 2,2'-azobis(2,4-dimethylvaleronitrile) was dissolved in 293 parts by weight of dipropylene glycol dimethyl ether to obtain another solution. The solution was fed dropwise into the flask over about four hours with another dropping pump. After the completion of dropwise addition of the polymerization initiator, the mixture was held at the same temperature for about four hours, then cooled to room temperature, and thereby yielded a copolymer solution having a solid content of 29.0 percent by weight and an acid value of 37.9 mg-KOH/g. The prepared copolymer had an acid value of 131 mg-KOH/g, a weight-average molecular weight Mw of 10000, and a polydispersity of 1.67.

### PREPARATION EXAMPLE 3

A suitable amount of nitrogen was fed into a 1-liter flask equipped with a reflux condenser, dropping funnels, and a stirrer to give a nitrogen atmosphere. In the flask was placed 275 parts by weight of dipropylene glycol dimethyl ether (175°C), followed by heating to 70°C with stirring. Next, 55 parts by weight of methacrylic acid (MAA), 180 parts by weight of a 50:50 (molar ratio) mixture (E-DCPA) of 3,4-epoxytricyclo[5.2.1.0^{2,6}]dec-9-yl acrylate and 3,4-epoxytricyclo[5.2.1.0^{2,6}]dec-8-yl acrylate, and 70 parts by weight of styrene were dissolved in 170 parts by weight of dipropylene glycol dimethyl ether to obtain a solution. The solution was fed dropwise into the flask over about four hours with a dropping pump. Independently, 30 parts by weight of a polymerization initiator 2,2'-azobis(2,4-dimethylvaleronitrile) was dissolved in 225 parts by weight of dipropylene glycol dimethyl ether to obtain another solution. The solution was fed dropwise into the flask over about four hours with another dropping pump. After the completion of dropwise addition of the polymerization initiator, the mixture was held at the same temperature for about four hours, then cooled to room temperature, and thereby yielded a copolymer solution having a solid content of 30.3 percent by weight and an acid val,ue of 35.7 mg-KOH/g. The prepared copolymer had an acid value of 118 mg-KOH/g, a weight-average molecular weight Mw of 8500, and a polydispersity of 1.64.

### PREPARATION EXAMPLE 4

The procedure of Preparation Example 1 was carried out, except for using 1,3-butanediol diacetate (232°C) as a solvent instead of dipropylene glycol dimethyl ether, to give a copolymer solution having a solid content of 30.3 percent by weight and an acid value of 35.7 mg-KOH/g. The prepared copolymer had an acid value of 118 mg-KOH/g, a weight-average molecular weight Mw of 10000, and a polydispersity of 1.70.

### PREPARATION EXAMPLE 5

The procedure of Preparation Example 1 was carried out, except for using propylene glycol monomethyl ether (120°C) as a solvent instead of dipropylene glycol dimethyl ether, to give a copolymer solution having a solid content of 30.3 percent by weight and an acid value of 35.7 mg-KOH/g. The prepared copolymer had an acid value of 118 mg-KOH/g, a weight-average molecular weight Mw of 7500, and a polydispersity of 1.70.

### PREPARATION EXAMPLE 6

The procedure of Preparation Example 1 was carried out, except for using ethylene glycol monoethyl ether (135°C) as a solvent instead of dipropylene glycol dimethyl ether, to give a copolymer solution having a solid content of 30.3 percent by weight and an acid value of 35.7 mg-KOH/g. The prepared copolymer had an acid value of 118 mg-KOH/g, a weight-average molecular weight Mw of 9000, and a polydispersity of 1.80.

### EXAMPLE 1 (Application by Slit Coating)

A curable resin composition was prepared by: diluting 100 kg of the copolymer solution prepared according to Preparation Example 1 with 20 kg of dipropylene glycol monomethyl ether acetate (213°C); dissolving therein 7.5 kg of 1,2-naphthoquinonediazido-5-sulfonic acid ester of 4,4'-[1-[4-(1-(4-hydroxyphenyl)-1-methylethyl)phenyl]ethylidene]diphenol (average degree of esterification of 66.7 percent by mole); and filtrating the resulting solution through a Millipore Filter with a pore diameter of 0.22 µm.
The curable resin composition was applied to a glass substrate through slit coating, prebaked at 80°C for five minutes, and thereby yielded a coat of 1.5 µm thickness.
The coat was in close contact with a predetermined patterned mask and irradiated with an ultraviolet ray having a light intensity at 365 nm of 10 mJ/cm² for 30 seconds. Subsequently, the exposed coat was developed with 0.12 percent by weight of aqueous solution of tetramethylammonium hydroxide at 25°C for two minutes, and rinsed with ultrapure water for one minute. By removing unnecessary portions via these operations, a pattern of 20 µm long and 20 µm wide was resolved. The coat was cured by exposing the entire resolved pattern to the light for 30 seconds using the same exposure system as above and heating the resulting coat bearing the pattern in a clean oven at 200°C for one hour, to thereby have characteristic properties necessary as a film (coating).

### EXAMPLE 2 (Application by Ink-jet Coating)

A curable resin composition was prepared by the procedure of Example 1.
Formation and patterning of a coat was conducted by the procedure of Example 1, except for forming a patterned coat through ink-jet coating without exposure and developing, instead of slit coating, and the coat was cured by the procedure of Example 1.

### EXAMPLE 3 (Application by Slit Coating)

A curable resin composition was prepared by the procedure of Example 1, except for using the copolymer solution prepared according to Preparation Example 2 instead of the copolymer solution prepared according to Preparation Example 1.
Formation of a coat, patterning, and curing of the coat were carried out by the procedure of Example 1, except for using the above-prepared curable resin composition.

### EXAMPLE 4 (Application by Ink-jet Coating)

A curable resin composition was prepared by the procedure of Example 1, except for using the copolymer solution prepared according to Preparation Example 2 instead of the copolymer solution prepared according to Preparation Example 1.
Formation of a coat, patterning, and curing of the coat were carried out by the procedure of Example 2, except for using the above-prepared curable resin composition.

### EXAMPLE 5 (Application by Slit Coating)

A curable resin composition was prepared by the procedure of Example 1, except for using the copolymer solution prepared according to Preparation Example 3 instead of the copolymer solution prepared according to Preparation Example 1.
Formation of a coat, patterning, and curing of the coat were carried out by the procedure of Example 1, except for using the above-prepared curable resin composition.

### EXAMPLE 6 (Application by Ink-jet Coating)

A curable resin composition was prepared by the procedure of Example 1, except for using the copolymer solution prepared according to Preparation Example 3 instead of the copolymer solution prepared according to Preparation Example 1.
Formation of a coat, patterning, and curing of the coat were carried out by the procedure of Example 2, except for using the above-prepared curable resin composition.

### EXAMPLE 7 (Application by Slit Coating)

A curable resin composition was prepared by: diluting 100 kg of the copolymer solution prepared according to Preparation Example 4 with 20 kg of 1,3-butanediol diacetate (232°C); dissolving therein 7.5 kg of 1,2-naphthoquinonediazido-5-sulfonic acid ester of 4,4'-[1-[4-(1-(4-hydroxyphenyl)-1-methylethyl)phenyl]ethylidene]diphenol (average degree of esterification of 66.7 percent by mole); and filtrating the resulting solution through a Millipore Filter with a pore diameter of 0.22 µm.
Formation of a coat, patterning, and curing of the coat were carried out by the procedure of Example 1, except for using the above-prepared curable resin composition.

### EXAMPLE 8 (Application by Ink-jet Coating)

A curable resin composition was prepared by the procedure of Example 7.
Formation of a coat, patterning, and curing of the coat were carried out by the procedure of Example 2, except for using the above-prepared curable resin composition.

### COMPARATIVE EXAMPLE 1 (Application by Slit Coating)

A curable resin composition was prepared by the procedure of Example 1, except for using the copolymer solution prepared according to Preparation Example 5 instead of the copolymer solution prepared according to Preparation Example 1, and except for using butyl acetate (125°C) as a solvent for the preparation of the composition instead of dipropylene glycol monomethyl ether acetate (213°C).
Formation of a coat, patterning, and curing of the coat were carried out by the procedure of Example 1, except for using the above-prepared curable resin composition.

### COMPARATIVE EXAMPLE 2 (Application by Ink-jet Coating)

A curable resin composition was prepared by procedure of Comparative Example 1.
Formation of a coat, patterning, and curing of the coat were carried out by the procedure of Example 2, except for using the above-prepared curable resin composition.

### COMPARATIVE EXAMPLE 3 (Application by Slit Coating)

A curable resin composition was prepared by the procedure of Example 1, except for using the copolymer solution prepared according to Preparation Example 6 instead of the copolymer solution prepared according to Preparation Example 1, and except for using propylene glycol monomethyl ether (120°C) instead of dipropylene glycol monomethyl ether acetate (213°C) as a solvent for the preparation of the composition.
Formation of a coat, patterning, and curing of the coat were carried out by the procedure of Example 1, except for using the above-prepared curable resin composition.

### COMPARATIVE EXAMPLE 4 (Application by Ink-jet Coating)

A curable resin composition was prepared by the procedure of Comparative Example 3.
Formation of a coat, patterning, and curing of the coat were carried out by the procedure of Example 2, except for using the above-prepared curable resin composition.

### Evaluation Tests

Coatability of the curable resin compositions prepared according to Examples and Comparative Examples, and properties typically of cured coatings prepared according to Examples and Comparative Examples were evaluated according to the following techniques. The results are shown in Table 1.

### Coatability

A coat operation was continuously repeated for ten hours or longer, and how the resulting coats are was visually observed. A sample whose coats have a uniform thickness without coating defects was evaluated as having "good" coatability, and one whose coats have uneven thickness and/or show coating defects was evaluated as having "poor" coatability.

### Transparency

A substrate bearing a sample cured coating was measured on transmittance at 400 to 800 nm with a spectrophotometer (Model 150-20 Double Beam Spectrophotometer, supplied by Hitachi Ltd.). A sample having a minimum transmittance of more than 95% was evaluated as having "good" transparency, one having a minimum transmittance of from 90% to 95% was evaluated as having "fair" transparency, and one having a minimum transmittance of less than 90% was evaluated as having "poor" transparency.

### Thermal Stability

Each of the substrates bearing a coat after patterning in Examples and Comparative Examples was heated in a clean oven at 250°C for one hour, and the thickness of the coat on the heated substrate was measured. A film residual rate was calculated as a percentage of the thickness of the heated coat to the thickness of the coat immediately after patterning. A sample showing a film residual rate of more than 95% was evaluated as having "good" thermal stability, one showing a film residual rate of from 90% to 95% was evaluated as having "fair" thermal stability, and one having a film residual rate of less than 90% was evaluated as having "poor" thermal stability.

### Resistance to Heat-induced Discoloration

Each of the substrates bearing a coat after curing of the coat in Examples and Comparative Examples was heated in a clean oven at 250°C for one hour, and the transmittance of each sample was measured with the same spectrophotometer as in the evaluation of transparency, and a change in transmittance was determined. A sample showing a change in transmittance of less than 5% was evaluated as having "good" resistance to heat-induced discoloration, one having a change in transmittance of from 5% to 10% was evaluated as having "fair" resistance to heat-induced discoloration, and one having a change in transmittance of more than 10% was evaluated as having "poor" resistance to heat-induced discoloration.

### Hardness

Each of the substrates bearing a coat after curing of the coat in Examples and Comparative Examples was subjected to a pencil scratch test in accordance with the "Pencil Scratch Test" according to Japanese Industrial Standards (JIS) K-5400-1990, 8.4.1; and a pencil hardness was measured based on scratching of the coat to thereby determine surface hardness of the coat.

### [Table 1]

**TABLE 1**

| | Application process | Coatability | Coating hardness | Transparency | Thermal stability | Resistance to heat-induced discoloration |
|---|---|---|---|---|---|---|
| Example 1 | Slit coat | Good | 4H | Good | Good | Good |
| Example 2 | Ink-jet coating | Good | 4H | Good | Good | Good |
| Example 3 | Slit coat | Good | 3H | Good | Good | Good |
| Example 4 | Ink-jet coating | Good | 3H | Good | Good | Good |
| Example 5 | Slit coat | Good | 4H | Good | Good | Good |
| Example 6 | Ink-jet coating | Good | 4H | Good | Good | Good |
| Example 7 | Slit coat | Good | 4H | Good | Good | Good |
| Example 8 | Ink-jet coating | Good | 4H | Good | Good | Good |
| Com. Ex.1 | Slit coat | Poor | 3H | Good | Good | Good |
| Com. Ex. 2 | Ink-jet coating | Poor | 3H | Good | Good | Good |
| Com. Ex. 3 | Slit coat | Poor | 3H | Good | Good | Good |
| Com. Ex. 4 | Ink-jet coating | Poor | 3H | Good | Good | Good |

### Industrial Applicability

The curable resin compositions according to the present invention can be stably stored and give coats (cured coatings) that are superior in characteristic properties such as hardness, transparency, thermal stability, and resistance to heat-induced discoloration. The curable resin compositions are therefore useful in application or coating through slit coating or ink-jet coating.

## Claims

1. A curable resin composition comprising a copolymer and an organic solvent having a boiling point of 180°C or higher at atmospheric pressure, the copolymer containing: monomer units (A) having an alkali-soluble group; and monomer units (B) corresponding to curable group-containing polymerizable unsaturated compounds,
wherein an amount of the monomer units (B) is 5 to 95 percent by weight based on the total weight of monomer units constituting the copolymer, and
wherein the monomer units (B) contain a monomer unit corresponding to a compound containing an 3,4-epoxytricyclo[5.2.1.0^{2,6}]decane ring and represented by following Formula (1a) or (1b): 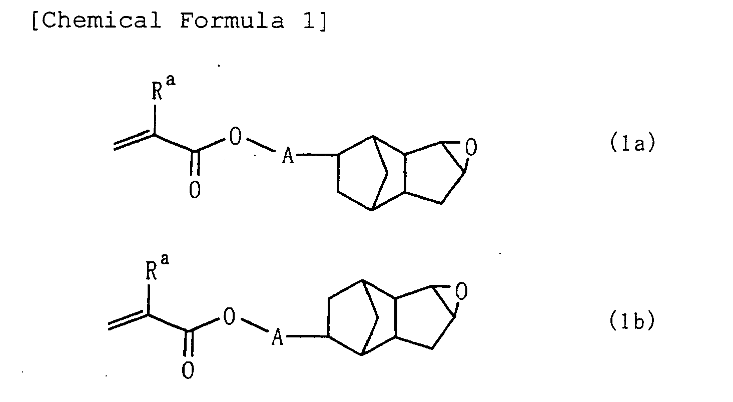 wherein R^{a}s independently represent a hydrogen atom or a hydroxyl-substituted or unsubstituted alkyl group having one to seven carbon atoms; and "A"s independently represent a single bond or a bivalent hydrocarbon group which may contain a hetero atom, and
a total amount of the monomer units corresponding to said compounds each represented by the Formula (1a) or (1b) is 30 percent by weight or more based on the total weight of the monomer units (B).

2. The curable resin composition of claim 1, wherein the copolymer further contain monomer units (C) corresponding to at least one curable group-free polymerizable unsaturated compound selected from a group consisting of: (c1) an alkyl-substituted or unsubstituted styrene; (c2) an unsaturated carboxylic acid ester represented by following Formula (2): 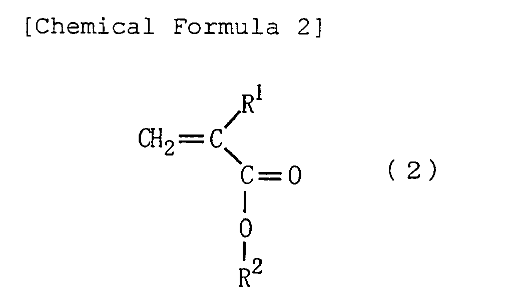 wherein R¹ represents a hydrogen atom or an alkyl group having one to seven carbon atoms; and R² represents a primary or secondary alkyl group having one to twelve carbon atoms, an alkenyl group having two to twelve carbon atoms, an aryl group, an aralkyl group, or a -(R³-O)ₘ-R⁴ group, wherein R³ represents a bivalent hydrocarbon group having one to twelve carbon atoms; R⁴ represents a hydrogen atom or a hydrocarbon group; and "m" denotes an integer of 1 or more; and
(c3) a N-substituted maleimide, in addition to the monomer units (A) and (B).

3. The curable resin composition of claim 1 or 2, wherein the compound containing an 3,4-epoxytricyclo[5.2.1.0^{2,6}]decane ring and represented by Formula (1a) or (1b) is selected from a group consisting of 3,4-epoxytricyclo[5.2.1.0^{2,6}]dec-9-yl (meth)acrylates, 3,4-epoxytricyclo[5.2.1.0^{2,6}]dec-8-yl (meth)acrylates, 2-(3,4-epoxytricyclo[5.2.1.0^{2,6}]dec-9-yloxy)ethyl (meth)acrylates, and 2-(3,4-epoxytricyclo[5.2.1.0^{2,6}]dec-8-yloxy)ethyl (meth)acrylates.

4. The curable resin composition of any one of claims 1 to 3, wherein the organic solvent having a boiling point of 180°C or higher at atmospheric pressure is at least one organic solvent selected from a group consisting of a C₅ or C₆ cycloalkanediol, a C₅ or C₆ cycloalkane-dimethanol, a C₅ or C₆ cycloalkanediol mono- or di-acetate, a C₅ or C₆ cycloalkane-dimethanol mono- or di-acetate, a propylene glycol mono- or di-aryl ether, a dipropylene glycol mono(C₁-C₄ alkyl) ether, a dipropylene glycol di(C₂-C₄ alkyl) ether, a dipropylene glycol mono(C₁-C₄ alkyl) ether acetate, a tripropylene glycol mono- or di-(C₁-C₄ alkyl) ether, propylene glycol diacetate, a 1,3-propanediol di(C₃ or C₄ alkyl) ether, a 1,3-propanediol mono(C₂-C₄ alkyl) ether acetate, 1,3-propanediol mono- or di-acetate, a 1,3-butanediol mono- or di-(C₃ or C₄ alkyl) ether, a 1,3-butanediol mono2-04 alkyl) ether acetate, 1,3-butanediol mono- or di-acetate, a 1,4-butanediol mono- or di-(C₃ or C₄ alkyl) ether, a 1,4-butanediol mono(C₂-C₄ alkyl) ether acetate, 1,4-butanediol mono- or di-acetate, a glycerol mono-, di-, or tri-(C₁-C₄ alkyl) ether, glycerol mono-, di-, or tri-acetate, a glycerol mono- or di-(C₁-C₄ alkyl) ether di- or mono-acetate, 3,5,5-trimethyl-2-cyclohexen-1-one, a diethylene glycol mono(C₂-C₄ alkyl) ether, and a diethylene glycol mono(C₂-C₄ alkyl) ether acetate.

5. A process for producing a cured coating, the process comprising: the step of applying the curable resin composition of any one of claims 1 to 4 to a substrate or base through slit coating or ink-jet coating to form a coat; and the step of curing the coat.
